(19)

Europäisches Patentamt

European Patent Office

Office européen des brevets

(11) **EP 4 531 313 A1**

(12) **EUROPEAN PATENT APPLICATION**
published in accordance with Art. 153(4) EPC

(43) Date of publication:
**02.04.2025 Bulletin 2025/14**

(21) Application number: **23822904.1**

(22) Date of filing: **26.05.2023**

(51) International Patent Classification (IPC):
**H04L 1/00** [(2006.01)]

(52) Cooperative Patent Classification (CPC):
**H04L 1/00**

(86) International application number:
**PCT/CN2023/096532**

(87) International publication number:
**WO 2023/241334 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.06.2022 CN 202210693015**

(71) Applicant: **Huawei Technologies Co., Ltd.
Shenzhen, Guangdong 518129 (CN)**

(72) Inventors:
• **WANG, Xianbin
Shenzhen, Guangdong 518129 (CN)**

• **TONG, Jiajie
Shenzhen, Guangdong 518129 (CN)**
• **ZHANG, Huazi
Shenzhen, Guangdong 518129 (CN)**
• **LI, Rong
Shenzhen, Guangdong 518129 (CN)**
• **WANG, Jun
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **COMMUNICATION METHOD AND APPARATUS**

(57) Embodiments of this application provide a communication method and apparatus, to reduce complexity of a polar code construction process. The method includes: obtaining a to-be-encoded bit sequence, where the to-be-encoded bit sequence includes K information bits, and K is an integer greater than 0; determining a first sequence, where positions of the K information bits in the first sequence are determined based on a second sequence corresponding to a target code rate and a value of K, the second sequence is used to represent selection priorities of $N_0$ bit positions, and $N_0$ is an integer greater than K; performing polar code encoding on the first sequence to obtain a third sequence; and sending the third sequence. The second sequence is designed for a constant code rate, and a same sequence may be used to construct a series of polar codes having a same code rate and different lengths. Compared with a Q sequence designed for different code rates and different code lengths, the second sequence in embodiments of this application can reduce power consumption of system implementation.

```
┌──────────────┐                    ┌──────────────┐
│ Transmit end │                    │ Receive end  │
└──────┬───────┘                    └──────┬───────┘
       │                                   │
┌──────┴───────────────────────────┐       │
│ S401: Obtain a to-be-encoded bit  │       │
│ sequence                          │       │
└──────┬────────────────────────────┘       │
       │                                     │
┌──────┴────────────────────────┐            │
│ S402: Determine a first        │            │
│ sequence                       │            │
└──────┬─────────────────────────┘            │
       │                                      │
┌──────┴────────────────────────────┐         │
│ S403: Perform polar code encoding  │         │
│ on the first sequence to obtain a  │         │
│ third sequence                     │         │
└──────┬─────────────────────────────┘         │
       │        S404: Send the third sequence   │
       │ ─────────────────────────────────────> │
       │                                        │
```

FIG. 4

Processed by Luminess, 75001 PARIS (FR)

# Description

## CROSS-REFERENCE TO RELATED APPLICATIONS

This application claims priority to Chinese Patent Application No. 202210693015.5, filed with the China National Intellectual Property Administration on June 17, 2022 and entitled "COMMUNICATION METHOD AND APPARATUS", which is incorporated herein by reference in its entirety.

## TECHNICAL FIELD

Embodiments of this application relate to the field of communication technologies, and in particular, to a communication method and apparatus.

## BACKGROUND

In a communication process based on polar (Polar) code encoding, if a code length for actual communication is different from a code length obtained by performing polar code encoding, a code length matching process needs to be implemented by performing puncturing, retransmission, or the like on a bit sequence obtained by performing polar code encoding, and then code construction is performed based on a code length matching result. Specifically, an example of performing code length matching in a puncturing manner is used. First, it is determined, based on the code length for actual communication and the code length obtained by performing polar code encoding, to perform code length matching in the puncturing manner, and then a to-be-punctured position is determined. After a to-be-punctured bit position is determined, an information position and a frozen position are determined for code construction. In the current new radio (new radio, NR) standard, this process is complex to implement and is not applicable to an ultra-low power consumption requirement.

## SUMMARY

Embodiments of this application provide a communication method and apparatus, to reduce complexity of a polar code construction process.

According to a first aspect, a communication method is provided. The method may be performed by a transmit end or a chip, a chip system, or a circuit located at the transmit end. The method may be implemented by using the following steps: obtaining a to-be-encoded bit sequence, where the to-be-encoded bit sequence includes K information bits, and K is an integer greater than 0; determining a first sequence, where positions of the K information bits in the first sequence are determined based on a second sequence corresponding to a target code rate and a value of K, the second sequence is used to represent selection priorities of $N_0$ bit positions, and $N_0$ is an integer greater than K; performing polar code encoding on the first sequence to obtain a third sequence; and sending the third sequence.

In embodiments of this application, the second sequence is designed for a constant code rate, and a same sequence may be used to construct a series of polar codes having a same code rate and different lengths. Compared with a Q sequence designed for different code rates and different code lengths, the second sequence in embodiments of this application can reduce power consumption of system implementation. Especially, in some scenarios in which only several code rates need to be supported but a large quantity of different code lengths need to be supported, the method provided in embodiments of this application can greatly reduce power consumption of system implementation.

In a possible design, before the sending the third sequence, the method further includes: puncturing $(N_0-E)$ bits in the third sequence, where E is a target code length, and E is an integer greater than 0 and less than or equal to $N_0$. In the foregoing manner, a sent code length can match the target code length.

In a possible design, a remainder obtained by performing a remainder operation on a sequence number of any bit in the $(N_0-E)$ bits in the third sequence based on $N_0/2$ satisfies a second criterion. In the foregoing manner, a length matching process (in other words, a process of determining a to-be-punctured bit) and a code construction process (a process of determining an information bit position) are independent of each other, so that implementation complexity can be reduced.

In a possible design, the second criterion is that the remainder is less than $(N_0/2-E/2)$.

In a possible design, the target code rate may alternatively correspond to a plurality of sequences. The plurality of sequences correspond to different code lengths, and the second sequence may be a sequence that is in the plurality of sequences corresponding to the target code rate and that has a correspondence with the target code length. In the implementation, $N_0 =$

$$2^{\wedge}(\lceil \log_2(E) \rceil)$$, and $\lceil\ \rceil$ represents rounding up. In the foregoing descriptions, different sequences are designed for different code lengths, so that a puncturing step can be omitted or simplified, thereby further reducing complexity.

In a possible design, the target code rate may correspond to one sequence, and the second sequence is the sequence corresponding to the target code rate. In the implementation, $N_0$ may be a preset value. In the foregoing design, a same sequence is designed for a same code rate and different code lengths, so that the same sequence can be used to construct a series of polar codes having a same code rate and different lengths, thereby reducing system complexity.

In a possible design, the target code rate may correspond to one sequence, and the transmit end may determine, based on the sequence, a sequence corresponding to the target code length. In other words, the second sequence is determined based on the sequence corresponding to the target code rate. In the foregoing design, a same sequence is designed for a same code rate and different code lengths, so that the same sequence can be used to construct a series of polar codes having a same code rate and different lengths, thereby reducing system complexity.

In a possible design, the positions of the K information bits in the first sequence are in one-to-one correspondence with first K bit positions in the $N_0$ bit positions sorted in descending order based on the selection priorities.

In a possible design, the second sequence includes $N_0$ values, an $n^{th}$ value in the second sequence is used to represent a selection priority of an $n^{th}$ bit position in the $N_0$ bit positions, and n traverses integers from 0 to $N_0$-1.

In a possible design, a value that is in the second sequence and that corresponds to a bit position used to place a frozen bit in the first sequence satisfies a first criterion; and a value that is in the second sequence and that corresponds to a bit position used to place the information bit in the first sequence does not satisfy the first criterion. In the foregoing manner, a length matching process (in other words, a process of determining a to-be-punctured bit) and a code construction process (a process of determining an information bit position) are independent of each other, so that implementation complexity can be reduced.

In a possible design, a value in the second sequence is inversely proportional to a selection priority, and the first criterion is that the value is greater than or equal to K; or a value in the second sequence is directly proportional to a selection priority, and the first criterion is that the value is less than or equal to ($N_0$ - K).

In a possible design, the target code rate is preset, or the target code rate is selected from a code rate set, and the code rate set includes one or more code rates.

According to a second aspect, a communication method is provided. The method may be performed by a receive end or a chip, a chip system, or a circuit located at the receive end. The method may be implemented by using the following steps: obtaining a third sequence; determining positions of K information bits, where the positions of the K information bits are determined based on a second sequence corresponding to a target code rate and a value of K, the second sequence is used to represent selection priorities of $N_0$ bit positions, and $N_0$ is an integer greater than K; and decoding the third sequence based on the positions of the K information bits.

In embodiments of this application, the second sequence is designed for a constant code rate, and a same sequence may be used to construct a series of polar codes having a same code rate and different lengths. Compared with a Q sequence designed for different code rates and different code lengths, the second sequence in embodiments of this application can reduce power consumption of system implementation. Especially, in some scenarios in which only several code rates need to be supported but a large quantity of different code lengths need to be supported, the method provided in embodiments of this application can greatly reduce power consumption of system implementation.

In a possible design, before the decoding the third sequence based on the positions of the K information bits, the method further includes: restoring ($N_0$-E) punctured bits in the third sequence, where E is a target code length, and E is an integer greater than 0 and less than or equal to $N_0$. In the foregoing manner, a sent code length can match the target code length.

In a possible design, a remainder obtained by performing a remainder operation on a sequence number of any bit in the ($N_0$-E) bits in the third sequence based on $N_0/2$ satisfies a second criterion. In the foregoing manner, a length matching process (in other words, a process of determining a to-be-punctured bit) and a code construction process (a process of determining an information bit position) are independent of each other, so that implementation complexity can be reduced.

In a possible design, the second criterion is that the remainder is less than ($N_0/2$-E/2).

In a possible design, the target code rate may alternatively correspond to a plurality of sequences. The plurality of sequences correspond to different code lengths, and the second sequence may be a sequence that is in the plurality of sequences corresponding to the target code rate and that has a correspondence with the target code length. In the implementation, $N_0 = 2^{\wedge}(\lceil \log_2(E) \rceil)$, and $\lceil \ \rceil$ represents rounding up. In the foregoing descriptions, different sequences are designed for different code lengths, so that a puncturing step can be omitted or simplified, thereby further reducing complexity.

In a possible design, the target code rate may correspond to one sequence, and the second sequence is the sequence corresponding to the target code rate. In the implementation, $N_0$ may be a preset value. In the foregoing design, a same sequence is designed for a same code rate and different code lengths, so that the same sequence can be used to construct a series of polar codes having a same code rate and different lengths, thereby reducing system complexity.

In a possible design, the target code rate may correspond to one sequence, and the second sequence is determined based on the sequence corresponding to the target code rate. In the foregoing design, a same sequence is designed for a same code rate and different code lengths, so that the same sequence can be used to construct a series of polar codes having a same code rate and different lengths, thereby reducing system complexity.

In a possible design, the positions of the K information bits are in one-to-one correspondence with first K bit positions in the $N_0$ bit positions sorted in descending order based on the selection priorities.

In a possible design, the second sequence includes $N_0$ values, an $n^{th}$ value in the second sequence is used to represent a selection priority of an $n^{th}$ bit position in the $N_0$ bit positions, and n traverses integers from 0 to $N_0-1$.

In a possible design, a value that is in the second sequence and that corresponds to a bit position used to place a frozen bit satisfies a first criterion; and a value that is in the second sequence and that corresponds to a bit position used to place the information bit does not satisfy the first criterion. In the foregoing manner, a length matching process (in other words, a process of determining a to-be-punctured bit) and a code construction process (a process of determining an information bit position) are independent of each other, so that implementation complexity can be reduced.

In a possible design, a value in the second sequence is inversely proportional to a selection priority, and the first criterion is that the value is greater than or equal to K; or a value in the second sequence is directly proportional to a selection priority, and the first criterion is that the value is less than or equal to $(N_0 - K)$.

In a possible design, the target code rate is preset, or the target code rate is selected from a code rate set, and the code rate set includes one or more code rates.

According to a third aspect, this application further provides a communication apparatus. The apparatus is a transmit-side device or a chip in the transmit-side device. The communication apparatus has a function of implementing any method provided in the first aspect. The communication apparatus may be implemented by hardware, or may be implemented by hardware executing corresponding software. The hardware or the software includes one or more units or modules corresponding to the foregoing function.

In a possible design, the communication apparatus includes a processor. The processor is configured to support the communication apparatus in performing corresponding functions of the transmit-side device in the foregoing methods. The communication apparatus may further include a memory. The memory may be coupled to the processor, and the memory stores program instructions and data essential for the communication apparatus. Optionally, the communication apparatus further includes an interface circuit. The interface circuit is configured to support communication between the communication apparatus and a device such as a receive-side device, for example, data or signal receiving and sending. For example, a communication interface may be a transceiver, a circuit, a bus, a module, or another type of communication interface.

In a possible design, the communication apparatus includes corresponding functional modules respectively configured to implement the steps in the foregoing methods. The function may be implemented by hardware, or may be implemented by hardware executing corresponding software. The hardware or the software includes one or more modules corresponding to the foregoing function.

In a possible design, a structure of the communication apparatus includes a processing unit (or a processing unit) and a communication unit (or a communication unit). These units may perform corresponding functions in the foregoing method examples. For details, refer to the descriptions in the method provided in the first aspect. Details are not described herein again.

According to a fourth aspect, this application further provides a communication apparatus. The apparatus is a receive-side device or a chip in the receive-side device. The communication apparatus has a function of implementing any method provided in the second aspect. The communication apparatus may be implemented by hardware, or may be implemented by hardware executing corresponding software. The hardware or the software includes one or more units or modules corresponding to the foregoing function.

In a possible design, the communication apparatus includes a processor. The processor is configured to support the communication apparatus in performing corresponding functions of the receive-side device in the foregoing methods. The communication apparatus may further include a memory. The memory may be coupled to the processor, and the memory stores program instructions and data essential for the communication apparatus. Optionally, the communication apparatus further includes an interface circuit. The interface circuit is configured to support communication between the communication apparatus and a device such as a transmit-side device, for example, data or signal receiving and sending. For example, a communication interface may be a transceiver, a circuit, a bus, a module, or another type of communication interface.

In a possible design, the communication apparatus includes corresponding functional modules respectively configured to implement the steps in the foregoing methods. The function may be implemented by hardware, or may be implemented by hardware executing corresponding software. The hardware or the software includes one or more modules corresponding to the foregoing function.

In a possible design, a structure of the communication apparatus includes a processing unit (or a processing unit) and a communication unit (or a communication unit). These units may perform corresponding functions in the foregoing method examples. For details, refer to the descriptions in the method provided in the second aspect. Details are not described herein again.

According to a fifth aspect, a communication apparatus is provided. The communication apparatus includes a processor and an interface circuit. The interface circuit is configured to receive a signal from a communication apparatus other than the communication apparatus and transmit the signal to the processor, or send a signal from the processor to a communication apparatus other than the communication apparatus. The processor is configured to implement the method in any one of the first aspect and the possible designs through a logic circuit or by executing code instructions.

According to a sixth aspect, a communication apparatus is provided. The communication apparatus includes a processor and an interface circuit. The interface circuit is configured to receive a signal from a communication apparatus other than the communication apparatus and transmit the signal to the processor, or send a signal from the processor to a communication apparatus other than the communication apparatus. The processor is configured to implement the method in any one of the second aspect and the possible designs through a logic circuit or by executing code instructions.

According to a seventh aspect, a computer-readable storage medium is provided. The computer-readable storage medium stores a computer program or instructions. When the computer program or the instructions are executed by a processor, the method in any one of the first aspect or the second aspect and the possible designs is implemented.

According to an eighth aspect, a computer program product storing instructions is provided. When the instructions are run by a processor, the method in any one of the first aspect or the second aspect and the possible designs is implemented.

According to a ninth aspect, a chip system is provided. The chip system includes a processor, and may further include a memory, configured to implement the method in any one of the first aspect or the second aspect and the possible designs. The chip system may include a chip, or may include a chip and another discrete component.

According to a tenth aspect, a communication system is provided. The system includes the apparatus (for example, a transmit-side device) according to the first aspect and the apparatus (for example, a receive-side device) according to the second aspect.

For technical effects that can be achieved by the technical solutions in any one of the third aspect to the tenth aspect, refer to descriptions of technical effects that can be achieved by the technical solutions in the first aspect. No repeated description is provided.

**BRIEF DESCRIPTION OF DRAWINGS**

FIG. 1 is a diagram of polar code encoding according to an embodiment of this application;
FIG. 2 is a diagram of an architecture of a communication system according to an embodiment of this application;
FIG. 3 is a diagram of interaction between a transmit end and a receive end according to an embodiment of this application;
FIG. 4 is a schematic flowchart of a communication method according to an embodiment of this application;
FIG. 5 is a diagram of a structure of a communication apparatus according to an embodiment of this application; and
FIG. 6 is a diagram of a structure of another communication apparatus according to an embodiment of this application.

**DESCRIPTION OF EMBODIMENTS**

To make objectives, technical solutions, and advantages of embodiments of this application clearer, the following further describes embodiments of this application in detail with reference to the accompanying drawings.

The following describes some terms in embodiments of this application, to facilitate understanding of a person skilled in the art.

(1) Polar (polar) code encoding: The polar code encoding is a channel encoding scheme that can be strictly proved to achieve a channel capacity, and has features such as high performance, low complexity, and flexible matching manners. Currently, the polar code encoding has been determined by the 3$^{rd}$ generation partnership project (3$^{rd}$ generation partnership project, 3GPP) as a control channel encoding scheme for a 5G control channel enhanced mobile broadband (enhanced mobile broadband, eMBB) scenario.

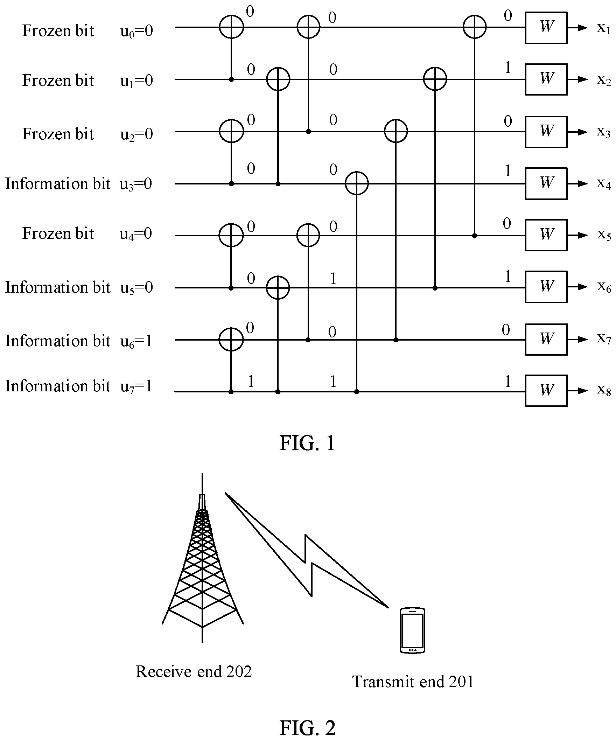

FIG. 1 shows a typical encoding process for a polar code with a length of 8. Bits in a to-be-encoded bit sequence are classified into two types based on reliability of the bits: a frozen bit (frozen) and an information bit (data). Generally, a bit with high reliability is set as the information bit (data), a bit with low reliability is set as the frozen bit (frozen), and a value of the frozen bit is generally set to 0, this is known to both a transmit end and a receive end in actual transmission. A code length in FIG. 1 is 8 bits (bits), {u0, u1, u2, u4} are positions of frozen bits, and {u3, u5, u6, u7} are positions of information bits. Each circle in each row represents an exclusive OR operation (or referred to as modulo-2 addition) between a bit in the row in which the circle is located and a row at which the circle arrives, and a bit on the right of the circle is a summation result.

(2) Nesting

For a given code rate, a polar code with a length of M may be divided into an upper half region and a lower half region. The upper half region and the lower half region respectively correspond to first M/2 bits and last M/2 bits. Construction of the polar code may be understood as that K information positions are properly allocated to the two half regions, and when the code rate is given, regardless of a code length, information position allocation percentages of the two half regions may remain unchanged. For example, an information position length of a polar code with a short code length is K1, an information position length of a polar code with a long code length is K2, and information position allocation percentages code length of the upper half region in the two code lengths are both P. As an information position length increases, information position lengths of the upper half region and the lower half region increase proportionally and equally. The information position length of the upper half region satisfies P*K1<P*K2, and the information position of the lower half region satisfies (1-P)*K1<(1-P)*K2. The polar code is constructed according to this principle, so that information positions of polar codes having a same code rate and different lengths satisfy nesting.

In embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression means any combination of these items (pieces), including a single item (piece) or any combination of a plurality of items (pieces). For example, at least one item (piece) of a, b, or c may indicate a, b, c, a-b, a-c, b-c, or a-b-c, where a, b, and c may be singular or plural.

In addition, unless otherwise stated on the contrary, ordinal terms such as "first" and "second" mentioned in embodiments of this application are used to distinguish between a plurality of objects, and are not intended to limit sizes, content, a sequence, a time sequence, priorities, importance degrees, or the like of the plurality of objects. For example, a first sequence and a second sequence are merely used to distinguish between different sequences, but do not indicate a difference in lengths, priorities, importance degrees, or the like between the two sequences.

The foregoing describes some terms in embodiments of this application. The following describes technical features in embodiments of this application.

It can be learned from the foregoing term descriptions that a mother code length obtained by performing polar code encoding is usually an integer power of 2. When a code length N for actual communication is not equal to a length obtained by performing polar code encoding, a code length matching process needs to be further implemented by performing puncturing, retransmission, or the like. Puncturing and retransmission refer to removing several bits from a bit sequence obtained through encoding or retransmitting several bits in the bit sequence obtained through encoding, to enable the bit sequence to meet a code length requirement.

Polar code construction is a process of obtaining polar code construction based on the given code length N and a given information bit length K. Currently, during construction of a polar code, a length matching manner such as puncturing (puncturing), retransmission, or shortening (shortening) needs to be first determined, then a pre-frozen position is removed based on the length matching manner, and then an information position of the polar code is obtained based on a Q sequence. The Q sequence is used to represent reliability of sub-channels. A value in the Q sequence represents a sequence number of a sub-channel, and a position of the value in the sequence represents reliability of the corresponding sub-channel. For example, for a Q sequence with a length of 8, [0 1 2 4 3 5 6 7] indicates that a channel whose sequence is 7 is a most reliable sub-channel, and a channel whose sequence is 6 is a second reliable channel. A polar code construction process is described with reference to the example. It is assumed to construct a polar code with lengths of N=6 and K=4. First, it is determined, based on a code rate, that the length matching manner is shortening, and then it is further determined that to-be-shortened positions are 6 and 7. Therefore, the sub-channel 6 and the sub-channel 7 are pre-frozen, in other words, the positions 6 and 7 cannot be selected as information positions. Therefore, before the polar code is constructed, 6 and 7 in the Q sequence are first removed, to obtain [0 1 2 4 3 5], then four positions, to be specific, 2, 4, 3, and 5, are selected from back to front as information positions, and the remaining position is used as a frozen position.

It can be learned that, in an existing polar code construction manner, length matching needs to be performed first, and then information position selection is performed. This implementation process is complex, and is not applicable to a requirement of an ultra-low power consumption scenario.

In view of this, embodiments of this application provide a communication method and apparatus, to reduce complexity of a polar code construction process. The method and the apparatus are based on a same concept. The method and the apparatus have a similar problem-resolving principle. Therefore, for implementations of the apparatus and the method, refer to each other. Repeated parts are not described again.

Embodiments of this application may be applied to a plurality of wireless communication fields that require channel encoding. For example, the wireless communication fields may include but are not limited to a 5G communication system, a future communication system (for example, a 6G communication system), a satellite communication system, a device-to-device (device-to-device, D2D) communication system, a machine-to-machine (machine-to-machine, M2M) communication system, an internet of things (internet of things, IoT) communication system, an uncrewed aerial vehicle communication system, a narrow band-internet of things (narrow band-internet of things, NB-IoT) system, a long term evolution (long term evolution, LTE) system, and three application scenarios of a 5G mobile communication system: eMBB, ultra reliable low latency communication (ultra reliable low latency communication, URLLC), and massive machine-type communications (massive machine-type communications, mMTC).

With reference to FIG. 2, the following describes a communication system to which an encoding and decoding method provided in embodiments of this application is applicable. FIG. 2 shows an architecture of a communication system. The communication system includes a transmit end 201 and a receive end 202. The transmit end 201 may be a network device or a terminal device, and the receive end 202 may be a network device or a terminal device. Optionally, when the transmit end 201 is the network device, the receive end 202 may be the terminal device. When the transmit end 201 is the terminal device, the receive end 202 may be the network device or the terminal device. For example, FIG. 2 shows that the transmit end 201 is the terminal device, and the receive end 202 is the network device. It should be noted that a quantity of devices in the communication system shown in FIG. 2 is merely an example, and is not intended to limit this application.

The network device may be a device having a wireless transceiver function or a chip that can be disposed in the network device. The network device includes but is not limited to: a base station (generation NodeB, gNB), a radio network controller (radio network controller, RNC), a NodeB (NodeB, NB), a base station controller (base station controller, BSC), a base transceiver station (base transceiver station, BTS), a home base station (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a satellite, an uncrewed aerial vehicle, a transmission point (transmission and reception point, TRP, or transmission point, TP), and the like. Alternatively, the network device may be a network node that constitutes a gNB or a transmission point, for example, a baseband unit (BBU), or a distributed unit (distributed unit, DU).

The terminal device may also be referred to as user equipment (user equipment, UE), an access terminal, a subscriber unit, a subscriber station, a mobile station, a remote station, a remote terminal, a mobile device, a user terminal, a terminal, a wireless communication device, a user agent, or a user apparatus. The terminal device in embodiments of this application may be a mobile phone (mobile phone), a tablet computer (tablet computer), a computer having a wireless transceiver function, a virtual reality (virtual reality, VR) terminal device, an augmented reality (augmented reality, AR) terminal device, a wireless terminal in industrial control (industrial control), a wireless terminal in self-driving (self-driving), a wireless terminal in telemedicine (remote medical), an uncrewed aerial vehicle, a wireless terminal in a smart grid (smart grid), a wireless terminal in transportation safety (transportation safety), a wireless terminal in a smart city (smart city), a smart wearable device (smart glasses, a smartwatch, a smart headset, or the like), a wireless terminal in a smart home (smart home), or the like. Alternatively, the terminal device may be a chip, a chip module (or a chip system), or the like that can be disposed in the foregoing device. In this application, a terminal device having a wireless transceiver function and a chip that can be disposed in the terminal device are collectively referred to as a terminal device.

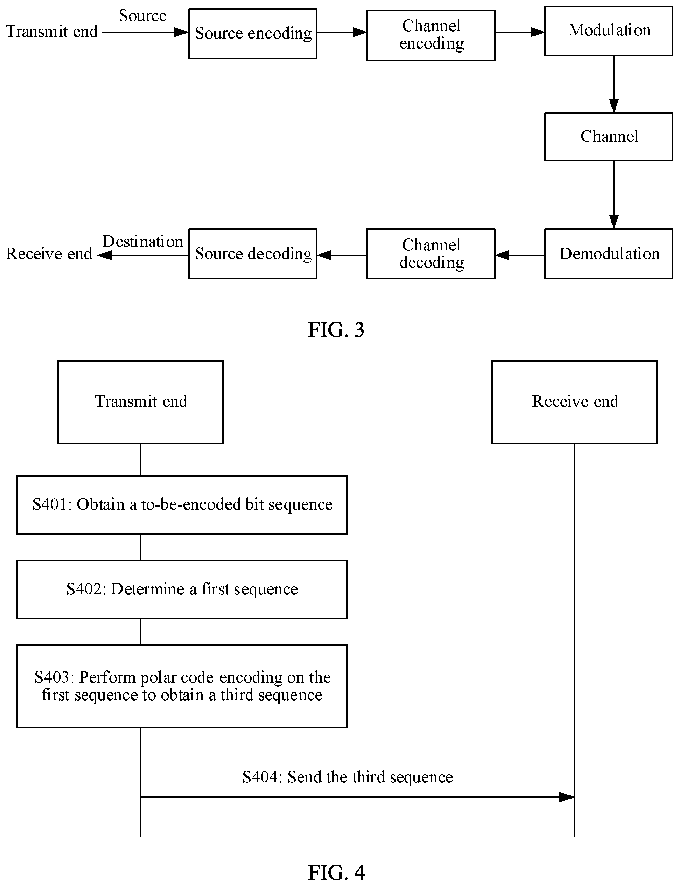

FIG. 3 is a diagram of an example of interaction between a transmit end and a receive end. A source of the transmit end is sent on a channel after source encoding, channel encoding, rate matching, and modulation are sequentially performed. After receiving a signal, the receive end obtains a destination after demodulation, rate de-matching, channel decoding, and source decoding are sequentially performed. The method provided in embodiments of this application may be used in a channel encoding process.

FIG. 4 is a schematic flowchart of a communication method according to this application. The method includes the following steps.

S401: A transmit end obtains a to-be-encoded bit sequence.

The to-be-encoded bit sequence includes K information bits, and K is an integer greater than 0.

S402: The transmit end determines a first sequence.

Positions of the K information bits in the first sequence are determined based on a second sequence corresponding to a target code rate and a value of K. The second sequence is used to represent selection priorities of $N_0$ bit positions, and $N_0$ is an integer greater than K. In this embodiment of this application, there is no strict correspondence between a value of $N_0$ and a mother code length of a polar code.

For example, the second sequence includes $N_0$ values. A position of a value in the second sequence represents a corresponding bit position, and the value represents a selection priority of the bit position, to be specific, an $n^{th}$ value in the second sequence is used to represent a selection priority of an $n^{th}$ bit position in the $N_0$ bit positions, and n traverses integers from 0 to $N_0-1$. In the second sequence, a value may be inversely proportional to a selection priority, to be specific, a larger value indicates a lower selection priority. Alternatively, a value may be directly proportional to a selection priority, to be specific, a larger value indicates a higher selection priority. How to determine the positions of the K information bits in the first sequence is described in detail below.

In a possible implementation, the target code rate may correspond to one sequence, and the second sequence is the sequence corresponding to the target code rate. In the implementation, $N_0$ may be a preset value.

In another possible implementation, the target code rate may alternatively correspond to a plurality of sequences. The plurality of sequences correspond to different code lengths, and the second sequence may be a sequence that is in the plurality of sequences corresponding to the target code rate and that has a correspondence with a target code length. In the implementation, $N_0 = 2\hat{}(\lceil \log_2(E) \rceil)$. E is the target code length, and $\lceil \rceil$ represents rounding up.

In the implementation, a sequence with a length of $N_0$ and a sequence with a length of $N_0 \times \left(\frac{1}{2}\right)^R$ in the sequences corresponding to the target code rate satisfy a nesting relationship, and R is an integer greater than 0. In a possible implementation, a maximum value of R may be 3.

In still another possible implementation, the target code rate may correspond to one sequence, and the transmit end may determine, based on the sequence, a sequence corresponding to a target code length. In other words, the second sequence is determined based on the sequence corresponding to the target code rate. Specifically, the second sequence and the sequence corresponding to the target code rate satisfy a nesting relationship, and the transmit end determines the second sequence based on the nesting relationship and the sequence corresponding to the target code rate.

A nesting relationship between a sequence 1 with a length of 512, a sequence 2 with a length of 256, a sequence 3 with a length of 128, and a sequence 4 with a length of 64 is used as an example for description below.

It is assumed that the sequence 1 with the length of 512 is [511, 510, 509, 505, 508, 503, 502, 491, 507, 501, 499, 487, 497, 483, 480, 457, 506, 498, 496, 482, 493, 477, 473, 448, 490, 472, 468, 441, 462, 433, 426, 387, 504, 494, 492, 474, 489, 470, 467, 438, 484, 463, 458, 427, 452, 419, 413, 370, 478, 455, 449, 416, 443, 408, 401, 356, 434, 397, 388, 343, 378, 331, 321, 269, 500, 488, 485, 465, 481, 459, 453, 421, 476, 451, 446, 411, 440, 404, 395, 350, 469, 442, 436, 399, 428, 389, 380, 333, 418, 377, 368, 319, 359, 308, 298, 235, 460, 430, 423, 383, 414, 372, 364, 314, 405, 360, 352, 300, 341, 289, 279, 207, 391, 346, 336, 284, 323, 271, 263, 191, 309, 260, 231, 178, 223, 165, 162, 144, 495, 479, 475, 450, 471, 444, 439, 402, 464, 435, 429, 390, 420, 379, 371, 322, 456, 425, 417, 376, 409, 366, 357, 306, 398, 354, 345, 294, 332, 281, 270, 171, 445, 410, 403, 358, 394, 349, 340, 288, 381, 334, 324, 272, 312, 247, 227, 138, 367, 318, 307, 229, 297, 213, 201, 115, 283, 198, 194, 102, 160, 97, 95, 77, 431, 392, 384, 337, 373, 325, 315, 251, 361, 310, 301, 203, 290, 193, 179, 113, 347, 296, 285, 175, 273, 159, 150, 90, 261, 143, 135, 73, 130, 65, 59, 42, 327, 275, 266, 146, 258, 137, 131, 71, 230, 123, 103, 57, 96, 52, 51, 25, 202, 98, 87, 49, 82, 41, 35, 20, 74, 34, 31, 19, 29, 17, 16, 6, 486, 466, 461, 432, 454, 422, 415, 374, 447, 412, 406, 362, 396, 351, 342, 291, 437, 400, 393, 348, 382, 335, 326, 274, 369, 320, 311, 252, 299, 248, 244, 232, 424, 385, 375, 328, 365, 316, 305, 249, 353, 302, 292, 243, 280, 238, 234, 216, 338, 286, 276, 233, 264, 225, 222, 208, 257, 221, 220, 205, 217, 204, 200, 196, 407, 363, 355, 304, 344, 293, 282, 237, 330, 278, 268, 224, 259, 212, 209, 184, 313, 262, 254, 206, 246, 195, 192, 176, 240, 189, 188, 172, 183, 170, 168, 164, 295, 250, 242, 190, 226, 187, 185, 157, 219, 182, 180, 156, 177, 154, 153, 148, 211, 174, 173, 155, 169, 152, 149, 140, 161, 147, 145, 136, 142, 133, 132, 128, 386, 339, 329, 277, 317, 265, 255, 199, 303, 253, 245, 167, 241, 151, 139, 117, 287, 239, 236, 141, 228, 129, 126, 110, 215, 124, 122, 108, 118, 105, 104, 100, 267, 218, 214, 125, 210, 121, 120, 93, 197, 116, 114, 92, 111, 89, 88, 81, 166, 109, 106, 86, 99, 84, 80, 72, 94, 79, 78, 70, 76, 69, 68, 64, 256, 186, 181, 119, 163, 112, 107, 60, 158, 101, 91, 58, 83, 56, 54, 48, 134, 85, 75, 53, 66, 50, 47, 40, 62, 45, 44, 38, 43, 37, 36, 32, 127, 67, 63, 39, 61, 33, 30, 18, 55, 28, 27, 15, 24, 14, 13, 5, 46, 26, 23, 12, 22, 11, 10, 4, 21, 9, 8, 3, 7, 2, 1, 0].

The sequence 1 is divided into an upper half region with a length of 256 and a lower half region with a length of 256. The upper half region is [511, 510, 509, 505, 508, 503, 502, 491, 507, 501, 499, 487, 497, 483, 480, 457, 506, 498, 496, 482, 493, 477, 473, 448, 490, 472, 468, 441, 462, 433, 426, 387, 504, 494, 492, 474, 489, 470, 467, 438, 484, 463, 458, 427, 452, 419, 413, 370, 478, 455, 449, 416, 443, 408, 401, 356, 434, 397, 388, 343, 378, 331, 321, 269, 500, 488, 485, 465, 481, 459, 453, 421, 476, 451, 446, 411, 440, 404, 395, 350, 469, 442, 436, 399, 428, 389, 380, 333, 418, 377, 368, 319, 359, 308, 298, 235, 460, 430, 423, 383, 414, 372, 364, 314, 405, 360, 352, 300, 341, 289, 279, 207, 391, 346, 336, 284, 323, 271, 263, 191, 309, 260, 231, 178, 223, 165, 162, 144, 495, 479, 475, 450, 471, 444, 439, 402, 464, 435, 429, 390, 420, 379, 371, 322, 456, 425, 417, 376, 409, 366, 357, 306, 398, 354, 345, 294, 332, 281, 270, 171, 445, 410, 403, 358, 394, 349, 340, 288, 381, 334, 324, 272, 312, 247, 227, 138, 367, 318, 307, 229, 297, 213, 201, 115, 283, 198, 194, 102, 160, 97, 95, 77, 431, 392, 384, 337, 373, 325, 315, 251, 361, 310, 301, 203, 290, 193, 179, 113, 347, 296, 285, 175, 273, 159, 150, 90, 261, 143, 135, 73, 130, 65, 59, 42, 327, 275, 266, 146, 258, 137, 131, 71, 230, 123, 103, 57, 96, 52, 51, 25, 202, 98, 87, 49, 82, 41, 35, 20, 74, 34, 31, 19, 29, 17, 16, 6]. The lower half region is [486, 466, 461, 432, 454, 422, 415, 374, 447, 412, 406, 362, 396, 351, 342, 291, 437, 400, 393, 348, 382, 335, 326, 274, 369, 320, 311, 252, 299, 248, 244, 232, 424, 385, 375, 328, 365, 316, 305, 249, 353, 302, 292, 243, 280, 238, 234, 216, 338, 286, 276, 233, 264, 225, 222, 208, 257, 221, 220, 205, 217, 204, 200, 196, 407, 363, 355, 304, 344, 293, 282, 237, 330, 278, 268, 224, 259, 212, 209, 184, 313, 262, 254, 206, 246, 195, 192, 176, 240, 189, 188, 172, 183, 170, 168, 164, 295, 250, 242, 190, 226, 187, 185, 157, 219, 182, 180, 156, 177, 154, 153, 148, 211, 174, 173, 155, 169, 152, 149, 140, 161, 147, 145, 136, 142, 133, 132, 128, 386, 339, 329, 277, 317, 265, 255, 199, 303, 253, 245, 167, 241, 151, 139, 117, 287, 239, 236, 141, 228, 129, 126, 110, 215, 124, 122, 108, 118, 105, 104, 100, 267, 218, 214, 125, 210, 121, 120, 93, 197, 116, 114, 92, 111, 89, 88, 81, 166, 109, 106, 86, 99, 84, 80, 72, 94, 79, 78, 70, 76, 69, 68, 64, 256, 186, 181, 119, 163, 112, 107, 60, 158, 101, 91, 58, 83, 56, 54, 48, 134, 85, 75, 53, 66, 50, 47, 40, 62, 45, 44, 38, 43, 37, 36, 32, 127, 67, 63, 39, 61, 33, 30, 18, 55, 28, 27, 15, 24, 14, 13, 5, 46, 26, 23, 12, 22, 11, 10, 4, 21, 9, 8, 3, 7, 2, 1, 0].

The sequence 2 with the length of 256 may include last 128 values in the upper half region of the sequence 1: [495, 479, 475, 450, 471, 444, 439, 402, 464, 435, 429, 390, 420, 379, 371, 322, 456, 425, 417, 376, 409, 366, 357, 306, 398, 354, 345, 294, 332, 281, 270, 171, 445, 410, 403, 358, 394, 349, 340, 288, 381, 334, 324, 272, 312, 247, 227, 138, 367, 318, 307, 229, 297, 213, 201, 115, 283, 198, 194, 102, 160, 97, 95, 77, 431, 392, 384, 337, 373, 325, 315, 251, 361, 310, 301, 203, 290, 193, 179, 113, 347, 296, 285, 175, 273, 159, 150, 90, 261, 143, 135, 73, 130, 65, 59, 42, 327, 275, 266, 146, 258, 137, 131, 71, 230, 123, 103, 57, 96, 52, 51, 25, 202, 98, 87, 49, 82, 41, 35, 20, 74, 34, 31, 19, 29, 17, 16, 6], and last 128 values in the lower half region of the sequence 1: [386, 339, 329, 277, 317, 265, 255, 199, 303, 253, 245, 167, 241, 151, 139, 117, 287, 239, 236, 141, 228, 129, 126, 110, 215, 124, 122, 108, 118, 105, 104, 100, 267, 218, 214, 125, 210, 121, 120, 93, 197, 116, 114, 92, 111, 89, 88, 81, 166, 109, 106, 86, 99, 84, 80, 72, 94, 79, 78, 70, 76, 69, 68, 64, 256, 186, 181, 119, 163, 112, 107, 60, 158, 101, 91, 58, 83, 56, 54, 48, 134, 85, 75, 53, 66, 50, 47, 40, 62, 45, 44, 38, 43, 37, 36, 32, 127, 67, 63, 39, 61, 33, 30, 18, 55, 28, 27, 15, 24, 14, 13, 5, 46, 26, 23, 12, 22, 11, 10, 4, 21, 9, 8, 3, 7, 2, 1, 0].

The sequence 3 with the length of 128 may include last 64 values in the upper half region of the sequence 1, in other words, last 64 values in an upper half region of the sequence 2: [431, 392, 384, 337, 373, 325, 315, 251, 361, 310, 301, 203, 290, 193, 179, 113, 347, 296, 285, 175, 273, 159, 150, 90, 261, 143, 135, 73, 130, 65, 59, 42, 327, 275, 266, 146, 258, 137, 131, 71, 230, 123, 103, 57, 96, 52, 51, 25, 202, 98, 87, 49, 82, 41, 35, 20, 74, 34, 31, 19, 29, 17, 16, 6], and last 64 values in the lower half region of the sequence 1, in other words, last 64 values in a lower half region of the sequence 2: [256, 186, 181, 119, 163, 112, 107, 60, 158, 101, 91, 58, 83, 56, 54, 48, 134, 85, 75, 53, 66, 50, 47, 40, 62, 45, 44, 38, 43, 37, 36, 32, 127, 67, 63, 39, 61, 33, 30, 18, 55, 28, 27, 15, 24, 14, 13, 5, 46, 26, 23, 12, 22, 11, 10, 4, 21, 9, 8, 3, 7, 2, 1, 0].

The sequence 4 with the length of 64 may include last 32 values in the upper half region of the sequence 1, in other words, last 32 values in the upper half region of the sequence 2, in other words, last 32 values in an upper half region of the sequence 3: [327, 275, 266, 146, 258, 137, 131, 71, 230, 123, 103, 57, 96, 52, 51, 25, 202, 98, 87, 49, 82, 41, 35, 20, 74, 34, 31, 19, 29, 17, 16, 6], and last 32 values in the lower half region of the sequence 1, in other words, last 32 values in the lower half region of the sequence 2, in other words, last 32 values in a lower half region of the sequence 3: [127, 67, 63, 39, 61, 33, 30, 18, 55, 28, 27, 15, 24, 14, 13, 5, 46, 26, 23, 12, 22, 11, 10, 4, 21, 9, 8, 3, 7, 2, 1, 0].

It may be understood that first sequences sent based on the sequence 1 to the sequence 4 are consistent based on the same target code length, the same target code rate, and the same to-be-encoded bit sequence.

Optionally, the positions of the K information bits in the first sequence are determined based on the second sequence corresponding to the target code rate and the value of K. Specifically, the positions of the K information bits in the first sequence may be in one-to-one correspondence with first K bit positions in the $N_0$ bit positions sorted in descending order based on the selection priorities.

In a possible implementation, the positions of the K information bits in the first sequence may be determined in the following manner: comparing each value in the second sequence with K. If the value satisfies a first criterion, a bit position corresponding to the value is used to place a frozen bit. Alternatively, if the value does not satisfy a first criterion, a bit position corresponding to the value is used to place an information bit.

In other words, the value that is in the second sequence and that corresponds to the bit position used to place the frozen bit in the first sequence satisfies the first criterion, and the value corresponding to the bit position used to place the information bit in the first sequence does not satisfy the first criterion.

For example, if a larger value in the second sequence indicates a lower selection priority, the first criterion may be that the value is greater than or equal to K. For another example, if a smaller value in the second sequence indicates a lower selection priority, the first criterion may be that the value is less than or equal to $(N_0-K)$.

In this embodiment of this application, the target code rate may be preset, or may be selected from a code rate set, and the code rate set includes one or more code rates.

It may be understood that a maximum quantity, namely, $\alpha*N_0$, of information bits supported by the second sequence may be determined based on a target code rate $\alpha$ and the value of $N_0$. In a possible implementation, the second sequence may include selection priorities corresponding to at least $\alpha*N_0$ bit positions, and selection priorities of all or some bit positions in the other $(N_0-\alpha*N_0)$ bit positions may be specific identifiers, for example, specific values.

For example, the target code rate is 1/2 the code rate, and $N_0$ is 512. It may be determined that the maximum quantity of information bits supported by the second sequence is 256, the second sequence includes selection priorities corresponding to 256 bit positions, and selection priorities of the other 256 bit positions may be X.

Because the second sequence supports a max-

imum of $\alpha*N_0$ bit positions, the other $(N_0-\alpha*N_0)$ bit positions are not used to place information bits. In the foregoing manner, the selection priorities of all or some bit positions in the other $(N_0-\alpha*N_0)$ bit positions are represented by the specific identifiers, so that complexity of the second sequence can be further reduced.

In this embodiment of this application, the second sequence is designed for a constant code rate, and a same sequence may be used to construct a series of polar codes having a same code rate and different lengths. Compared with a Q sequence designed for different code rates and different code lengths, the second sequence in this embodiment of this application can reduce power consumption of system implementation. Especially, in some extremely simple scenarios in which only several code rates need to be supported but a large quantity of different code lengths need to be supported, the method provided in this embodiment of this application can greatly reduce power consumption of system implementation.

S403: The transmit end performs polar code encoding on the first sequence to obtain a third sequence.

S404: The transmit end sends the third sequence. Correspondingly, a receive end receives the third sequence.

It should be understood that, S404 is merely intended to simplify descriptions, and during specific implementation, operations such as rate matching, modulation, and frequency conversion may be further included. Correspondingly, the third sequence received by the receive end is actually a signal received through a spatial channel after operations such as rate matching, modulation, and frequency conversion are performed on the third sequence. This is not distinguished in this application without affecting understanding.

In a possible implementation, after receiving the third sequence, the receive end decodes the third sequence based on the positions of the K information bits. A manner of determining the positions of the K information bits is the same as a manner in which the transmit end determines the positions of the K information bits. For details, refer to descriptions for the transmit end. Details are not described herein again.

In a possible implementation, before sending the third sequence, the transmit end may puncture $(N_0-E)$ bits in the third sequence. E is the target code length, and E is an integer greater than 0 and less than or equal to $N_0$. Correspondingly, before decoding the third sequence based on the positions of the K information bits, the receive end may restore the $(N_0-E)$ punctured bits in the third sequence. For example, positions of the $(N_0-E)$ punctured bits in the third sequence may be determined, and the $(N_0-E)$ punctured bits are filled with 0.

A manner in which the receive end determines the positions of the $(N_0-E)$ punctured bits in the third sequence is the same as a manner in which the transmit end determines the positions of the $(N_0-E)$ bits. For details, refer to the manner in which the transmit end determines the positions of the $(N_0-E)$ bits. Repeated parts are not described again.

Optionally, the $(N_0-E)$ bits may be determined in the following manner: performing a remainder operation on a sequence number i of each bit in the third sequence based on $N_0/2$. If a remainder satisfies a second criterion, it is determined that the bit needs to be punctured, in other words, the bit belongs to the $(N_0-E)$ bits. If a remainder does not satisfy a second criterion, it is determined that the bit is not punctured (in other words, the bit is reserved), in other words, the bit does not belong to the $(N_0-E)$ bits. i traverses integers from 0 to $N_0-1$.

In other words, a remainder obtained by performing a remainder operation on a sequence number of any bit in the $(N_0-E)$ bits in the third sequence based on $N_0/2$ satisfies the second criterion.

For example, the second criterion may be that the remainder is less than $(N_012-E/2)$.

For ease of understanding of this embodiment of this application, an example in which K=32 and E=64 is used to describe a polar code construction process with reference to the sequence 1. Assuming that a larger value in the sequence 1 indicates a lower selection priority, a polar code construction and sending process may include the following A1 to A4 implementations.

A1: Determine positions of 32 information bits of the to-be-encoded bit sequence in the first sequence.

Specifically, each value in the sequence 1 may be compared with K, that is, 32. If the value is greater than or equal to 32, a bit position corresponding to the value is used to place the frozen bit. If the value is less than 32, a bit position corresponding to the value is used to place the information bit.

According to step A1, for bit positions for placing frozen bits and bit positions for placing information bits in the first sequence, refer to the following sequence. 1 indicates the bit positions used to place the information bits, and 0 indicates the bit positions used to place the frozen bits: [0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 1, 0, 0, 0, 0, 0, 0, 0, 1, 0, 0, 1, 1, 1, 1, 1, 1, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 0, 1, 1, 0, 1, 1, 1, 1, 1, 1, 1, 0, 1, 1, 1, 1, 1, 1, 1, 1, 1, 1, 1, 1, 1, 1, 1].

It should be understood that this is merely an example for description herein. During specific implementation, 0 may alternatively indicate the bit positions used to place the information bits, and 1 may indicate the bit positions used to place the frozen bits.

It should be noted that the foregoing sequence is merely used to show the bit positions for placing the frozen bits and the bit positions for placing the information bits in the first sequence, and does not indicate values of bits in the first sequence. In the foregoing sequence, the frozen bits may be placed in bit positions corresponding to 480 0s, and the 32 information bits of the to-be-encoded bit sequence may be placed in bit positions corresponding to 32 1s.

A2: Perform polar code encoding on the first sequence to obtain the third sequence.

A3: Puncture 448 bits in the third sequence.

Specifically, i may traverse integers from 0 to $N_0$-1. If rem (i, $N_0$/2) is less than ($N_0$/2-E/2), an $i^{th}$ bit in the first sequence is punctured. If rem (i, $N_0$/2) is not less than ($N_0$/2-E/2), an $i^{th}$ bit in the first sequence is not punctured. In this case, a first bit to a $224^{th}$ bit and a $257^{th}$ bit to a $480^{th}$ bit in the first sequence are punctured.

A4: Send a punctured third sequence.

In this embodiment of this application, the second sequence is designed for a constant code rate, and a same sequence may be used to construct a series of polar codes having a same code rate and different lengths. Compared with the Q sequence designed for different code rates and different code lengths, the second sequence in this embodiment of this application can reduce power consumption of system implementation. Especially, in some extremely simple scenarios in which only several code rates need to be supported but a large quantity of different code lengths need to be supported, the method provided in this embodiment of this application can greatly reduce power consumption of system implementation.

In addition, in this embodiment of this application, a length matching process (in other words, a process of determining a to-be-punctured bit) and a code construction process (a process of determining an information bit position) are independent of each other, so that implementation complexity can be reduced. In addition, in this embodiment of this application, both the length matching process and the code construction process can ensure nesting of the polar code, in other words, information position lengths of an upper half region and a lower half region of the polar code increase proportionally and equally, so that communication performance can be ensured.

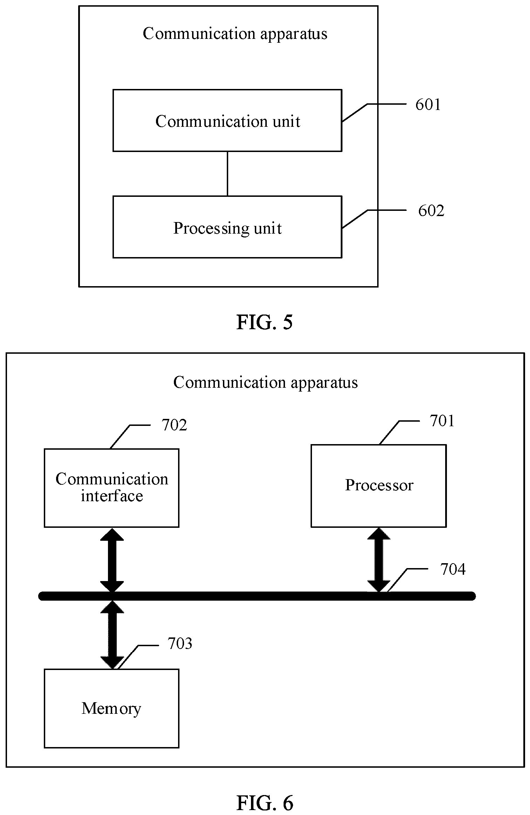

Based on a same inventive concept as the method embodiments, an embodiment of this application provides a communication apparatus. A structure of the communication apparatus may be shown in FIG. 5. The communication apparatus includes a communication unit 601 and a processing unit 602.

In an implementation, the communication apparatus may be specifically configured to implement the method performed by the transmit end in the embodiment in FIG. 4. The apparatus may be the transmit end, or may be a chip, a chip group, or a part of the chip configured to perform a related method function, in the transmit end. The processing unit 602 is configured to: obtain a to-be-encoded bit sequence, where the to-be-encoded bit sequence includes K information bits, and K is an integer greater than 0; determine a first sequence, where positions of the K information bits in the first sequence are determined based on a second sequence corresponding to a target code rate and a value of K, the second sequence is used to represent selection priorities of $N_0$ bit positions, and $N_0$ is an integer greater than K; and perform polar code encoding on the first sequence to obtain a third sequence. The communication unit 601 is configured to send the third sequence.

Optionally, the processing unit 602 is further configured to: before the third sequence is sent, puncture ($N_0$-E) bits in the third sequence, where E is a target code length, and E is an integer greater than 0 and less than or equal to $N_0$.

For example, a remainder obtained by performing a remainder operation on a sequence number of any bit in the ($N_0$-E) bits in the third sequence based on $N_0$/2 satisfies a second criterion.

For example, the second criterion is that the remainder is less than ($N_0$/2-E/2).

For example, $$N_0 = 2^{\wedge}(\lceil \log_2(E) \rceil)$$, or $N_0$ is a preset value.

For example, the positions of the K information bits in the first sequence are in one-to-one correspondence with first K bit positions in the $N_0$ bit positions sorted in descending order based on the selection priorities.

For example, the second sequence includes $N_0$ values, an $n^{th}$ value in the second sequence is used to represent a selection priority of an $n^{th}$ bit position in the $N_0$ bit positions, and n traverses integers from 0 to $N_0$-1.

For example, a value that is in the second sequence and that corresponds to a bit position used to place a frozen bit in the first sequence satisfies a first criterion; and a value that is in the second sequence and that corresponds to a bit position used to place the information bit in the first sequence does not satisfy the first criterion.

For example, a value in the second sequence is inversely proportional to a selection priority, and the first criterion is that the value is greater than or equal to K; or a value in the second sequence is directly proportional to a selection priority, and the first criterion is that the value is less than or equal to ($N_0$ - K).

For example, the target code rate is preset, or the target code rate is selected from a code rate set, and the code rate set includes one or more code rates.

In an implementation, the communication apparatus shown in FIG. 5 may be specifically configured to implement the method performed by the receive end in the embodiment in FIG. 4. The apparatus may be the receive end, or may be a chip, a chip group, or a part of the chip configured to perform a related method function, in the receive end. The communication unit 601 is configured to obtain a third sequence. The processing unit 602 is configured to: determine positions of K information bits, where the positions of the K information bits are determined based on a second sequence corresponding to a target code rate and a value of K, the second sequence is used to represent selection priorities of $N_0$ bit positions, and $N_0$ is an integer greater than K; and decode the third sequence based on the positions of the K information bits.

Optionally, the processing unit 602 is further configured to: before decoding the third sequence based on the positions of the K information bits, restore ($N_0$-E) punctured bits in the third sequence, where E is a target code length, and E is an integer greater than 0 and less than or equal to $N_0$.

For example, a remainder obtained by performing a remainder operation on a sequence number of any bit in the ($N_0$-E) bits in the third sequence based on $N_0$/2 satisfies a second criterion.

For example, the second criterion is that the remainder is less than ($N_0$/2-E/2).

For example, $N_0 = 2^{\wedge}(\lceil \log_2(E) \rceil)$, and $\lceil \rceil$ represents rounding up.

For example, the positions of the K information bits are in one-to-one correspondence with first K bit positions in the $N_0$ bit positions sorted in descending order based on the selection priorities.

For example, the second sequence includes $N_0$ values, an $n^{th}$ value in the second sequence is used to represent a selection priority of an $n^{th}$ bit position in the $N_0$ bit positions, and n traverses integers from 0 to $N_0$-1.

For example, a value that is in the second sequence and that corresponds to a bit position used to place a frozen bit satisfies a first criterion; and a value that is in the second sequence and that corresponds to a bit position used to place the information bit does not satisfy the first criterion. In the foregoing manner, a length matching process (in other words, a process of determining a to-be-punctured bit) and a code construction process (a process of determining an information bit position) are independent of each other, so that implementation complexity can be reduced.

For example, a value in the second sequence is inversely proportional to a selection priority, and the first criterion is that the value is greater than or equal to K; or a value in the second sequence is directly proportional to a selection priority, and the first criterion is that the value is less than or equal to ($N_0$ - K).

For example, the target code rate is preset, or the target code rate is selected from a code rate set, and the code rate set includes one or more code rates.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The integrated module may be implemented in a form of hardware, or may be implemented in a form of a software functional module. It may be understood that for functions or implementations of the modules in this embodiment of this application, further refer to related description in the method embodiments.

In a possible manner, the communication apparatus may be shown in FIG. 6. The apparatus may be a communication device or a chip in the communication device. The communication device may be the terminal device in the foregoing embodiment or the network device in the foregoing embodiment. The apparatus includes a processor 701 and a communication interface 702, and may further include a memory 703. The processing unit 602 may be the processor 701. The communication unit 601 may be the communication interface 702. Optionally, the processor 701 and the memory 703 may be integrated together.

The processor 701 may be a CPU, a digital processing unit, or the like. The communication interface 702 may be a transceiver, an interface circuit, for example, a transceiver circuit, a transceiver chip, or the like. The apparatus further includes the memory 703, configured to store a program executed by the processor 701. The memory 703 may be a non-volatile memory, for example, a hard disk drive (hard disk drive, HDD) or a solid-state drive (solid-state drive, SSD), or may be a volatile memory (volatile memory), for example, a random-access memory (random-access memory, RAM). The memory 703 is any other medium that can be used to carry or store expected program codes in a form of instructions or a data structure and that can be accessed by a computer, but is not limited thereto.

The processor 701 is configured to execute the program code stored in the memory 703, and is specifically configured to perform an action of the processing unit 602. Details are not described herein again in this application. The communication interface 702 is specifically used to perform an action of the communication unit 601. Details are not described herein again in this application.

A specific connection medium between the communication interface 702, the processor 701, and the memory 703 is not limited in embodiments of this application. In this embodiment of this application, the memory 703, the processor 701, and the communication interface 702 are connected to each other through a bus 704 in FIG. 6. The bus is represented by a bold line in FIG. 6, and a connection manner between other components is merely described as an example, and is not limited thereto. The bus may include an address bus, a data bus, a control bus, and the like. For ease of representation, only one bold line is used to represent the bus in FIG. 6, but this does not mean that there is only one bus or only one type of bus.

An embodiment of the present invention further provides a computer-readable storage medium, configured to store computer software instructions that need to be executed for execution of the foregoing processor, and the computer-readable storage medium includes a program that needs to be executed for execution of the foregoing processor.

An embodiment of this application further provides a communication system, including a communication apparatus configured to implement functions of the transmit end in the embodiment in FIG. 4 and a communication apparatus configured to implement functions of the receive end in the embodiment in FIG. 4.

A person skilled in the art should understand that embodiments of this application may be provided as a method, a system, or a computer program product. Therefore, this application may use a form of hardware-only embodiments, software-only embodiments, or embodiments combining software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of another programmable data processing device to generate a machine, so that the instructions executed by a computer or the processor of the another programmable data processing device generate an apparatus for implementing a specific function in one or more processes in the flowcharts and/or one or more blocks in the block diagrams.

These computer program instructions may alternatively be stored in a computer-readable memory that can instruct a computer or another programmable data processing device to work in a specific manner, so that the instructions stored in the computer-readable memory generate an artifact that includes an instruction apparatus. The instruction apparatus implements a specific function in one or more processes in the flowcharts and/or one or more blocks in the block diagrams.

These computer program instructions may alternatively be loaded onto a computer or another programmable data processing device, so that a series of operations and steps are performed on the computer or the another programmable device to generate computer-implemented processing. Therefore, the instructions executed on the computer or the another programmable device provide steps for implementing a specific function in one or more processes in the flowcharts and/or one or more blocks in the block diagrams.

It is clear that a person skilled in the art can make various modifications and variations to this application without departing from the scope of this application. This application is intended to cover these modifications and variations of this application provided that they fall within the scope of protection defined by the following claims and their equivalent technologies.

**Claims**

1. A communication method, wherein the method comprises:

   obtaining a to-be-encoded bit sequence, wherein the to-be-encoded bit sequence comprises K information bits, and K is an integer greater than 0;
   determining a first sequence, wherein positions of the K information bits in the first sequence are determined based on a second sequence corresponding to a target code rate and a value of K, the second sequence is used to represent selection priorities of $N_0$ bit positions, and $N_0$ is an integer greater than K;
   performing polar code encoding on the first sequence to obtain a third sequence; and
   sending the third sequence.

2. The method according to claim 1, wherein before the sending the third sequence, the method further comprises:
   puncturing $(N_0-E)$ bits in the third sequence, wherein E is a target code length, and E is an integer greater than 0 and less than $N_0$.

3. The method according to claim 2, wherein a remainder obtained by performing a remainder operation on a sequence number of any bit in the $(N_0-E)$ bits in the third sequence based on $N_0/2$ satisfies a second criterion.

4. The method according to claim 3, wherein the second criterion is that the remainder is less than $(N_0/2-E/2)$.

5. The method according to any one of claims 1 to 4, wherein $N_0 = 2\text{\^{}}(\lceil \log_2(E) \rceil)$, or $N_0$ is a preset

value, and $\lceil \rceil$ represents rounding up.

6. The method according to any one of claims 1 to 5, wherein the positions of the K information bits in the first sequence are in one-to-one correspondence with first K bit positions in the $N_0$ bit positions sorted in descending order based on the selection priorities.

7. The method according to any one of claims 1 to 6, wherein the second sequence comprises $N_0$ values, an $n^{th}$ value in the second sequence is used to represent a selection priority of an $n^{th}$ bit position in the $N_0$ bit positions, and n traverses integers from 0 to $N_0$-1.

8. The method according to claim 7, wherein a value that is in the second sequence and that corresponds to a bit position used to place a frozen bit in the first sequence satisfies a first criterion; and a value that is in the second sequence and that corresponds to a bit position used to place the information bit in the first sequence does not satisfy the first criterion.

9. The method according to claim 8, wherein a value in the second sequence is inversely proportional to a selection priority, and the first criterion is that the value is greater than or equal to K; or a value in the second sequence is directly proportional to a selection priority, and the first criterion is that the value is less than or equal to $(N_0 - K)$.

10. The method according to any one of claims 1 to 9, wherein the target code rate is preset, or the target code rate is selected from a code rate set, and the code rate set comprises one or more code rates.

11. A communication method, wherein the method comprises:

   obtaining a third sequence;
   determining positions of K information bits, wherein the positions of the K information bits are determined based on a second sequence corresponding to a target code rate and a value of K, the second sequence is used to represent selection priorities of $N_0$ bit positions, and $N_0$ is an integer greater than K; and
   decoding the third sequence based on the positions of the K information bits.

12. A communication apparatus, wherein the apparatus comprises:

   a processing unit, configured to: obtain a to-be-encoded bit sequence, wherein the to-be-encoded bit sequence comprises K information bits, and K is an integer greater than 0;
   determine a first sequence, wherein positions of the K information bits in the first sequence are determined based on a second sequence corresponding to a target code rate and a value of K, the second sequence is used to represent selection priorities of $N_0$ bit positions, and $N_0$ is an integer greater than K; and
   perform polar code encoding on the first sequence to obtain a third sequence; and
   a communication unit, configured to send the third sequence.

13. The apparatus according to claim 12, wherein the processing unit is further configured to:
   before the third sequence is sent, puncture $(N_0-E)$ bits in the third sequence, wherein E is a target code length, and E is an integer greater than 0 and less than $N_0$.

14. The apparatus according to claim 13, wherein a remainder obtained by performing a remainder operation on a sequence number of any bit in the $(N_0-E)$ bits in the third sequence based on $N_0/2$ satisfies a second criterion.

15. The apparatus according to claim 14, wherein the second criterion is that the remainder is less than $(N_0/2-E/2)$.

16. The apparatus according to any one of claims 12 to 15, wherein $N_0 = 2\wedge(\lceil \log_2(E) \rceil)$, or $N_0$ is a preset value.

17. The apparatus according to any one of claims 12 to 16, wherein the positions of the K information bits in the first sequence are in one-to-one correspondence with first K bit positions in the $N_0$ bit positions sorted in descending order based on the selection priorities.

18. The apparatus according to any one of claims 12 to 17, wherein the second sequence comprises $N_0$ values, an $n^{th}$ value in the second sequence is used to represent a selection priority of an $n^{th}$ bit position in the $N_0$ bit positions, and n traverses integers from 0 to $N_0$-1.

19. The apparatus according to claim 18, wherein a value that is in the second sequence and that corresponds to a bit position used to place a frozen bit in the first sequence satisfies a first criterion; and a value that is in the second sequence and that corresponds to a bit position used to place the information bit in the first sequence does not satisfy the first criterion.

20. The apparatus according to claim 19, wherein a value in the second sequence is inversely proportional to a selection priority, and the first criterion is that the value is greater than or equal to K; or a value in the second sequence is directly proportional to a selection priority, and the first criterion is that the value is less than or equal to ($N_0$ - K).

21. The apparatus according to any one of claims 12 to 20, wherein the target code rate is preset, or the target code rate is selected from a code rate set, and the code rate set comprises one or more code rates.

22. A communication apparatus, wherein the apparatus comprises:

   a communication unit, configured to obtain a third sequence; and
   a processing unit, configured to: determine positions of K information bits, wherein the positions of the K information bits are determined based on a second sequence corresponding to a target code rate and a value of K, the second sequence is used to represent selection priorities of $N_0$ bit positions, and $N_0$ is an integer greater than K; and
   decode the third sequence based on the positions of the K information bits.

23. A communication apparatus, comprising a processor, wherein the processor is configured to run a group of programs, so that the method according to any one of claims 1 to 10 is performed, or the method according to claim 11 is performed.

24. The apparatus according to claim 23, further comprising a memory, wherein the memory stores the programs run by the processor.

25. The apparatus according to claim 23 or 24, wherein the apparatus is a chip or an integrated circuit.

26. A computer-readable storage medium, wherein the computer storage medium stores computer-readable instructions, and when the computer-readable instructions are run on a communication apparatus, the method according to any one of claims 1 to 10 is performed, or the method according to claim 11 is performed.

27. A computer program product, wherein when the computer program product runs on a device, the device is enabled to perform the method according to any one of claims 1 to 10 or the method according to claim 11.

28. A communication system, wherein the system comprises the apparatus according to any one of claims 12 to 21 and the apparatus according to claim 22.

FIG. 1

Receive end 202          Transmit end 201

FIG. 2

Transmit end ——Source——▶ Source encoding ──▶ Channel encoding ──▶ Modulation

Modulation ──▶ Channel

Channel ──▶ Demodulation

Receive end ◀——Destination—— Source decoding ◀── Channel decoding ◀── Demodulation

**FIG. 3**

Transmit end

Receive end

S401: Obtain a to-be-encoded bit sequence

S402: Determine a first sequence

S403: Perform polar code encoding on the first sequence to obtain a third sequence

S404: Send the third sequence ──────────────────▶

**FIG. 4**

**FIG. 5**

**FIG. 6**

## INTERNATIONAL SEARCH REPORT

| | International application No. |
|---|---|
| | **PCT/CN2023/096532** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT, VEN, ENTXT, 3GPP, CJFD, IEEE: 比特, 编码, 信息, 极化码, 码率, 位置, 序列, 优先级, bit, encode, information, Polar, code, rate, location, sequence, priority

**C. DOCUMENTS CONSIDERED TO BE RELEVANT**

| Category* | Citation of document, with indication, where appropriate, of the relevant passages | Relevant to claim No. |
|---|---|---|
| Y | CN 110048726 A (HUAWEI TECHNOLOGIES CO., LTD.) 23 July 2019 (2019-07-23) description, paragraphs [0160]-[0498] | 1-2, 5-13, 16-28 |
| Y | CN 109150378 A (HUAWEI TECHNOLOGIES CO., LTD.) 04 January 2019 (2019-01-04) description, paragraphs [0005]-[0020] | 1-2, 5-13, 16-28 |
| A | WO 2018127155 A1 (NTT DOCOMO, INC.) 12 July 2018 (2018-07-12) entire document | 1-28 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **07 September 2023** | **10 September 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/096532**

| Patent document cited in search report | | | Publication date (day/month/year) | Patent family member(s) | | | Publication date (day/month/year) |
|---|---|---|---|---|---|---|---|
| CN | 110048726 | A | 23 July 2019 | EP | 3609079 | A1 | 12 February 2020 |
| | | | | EP | 3609079 | A4 | 15 April 2020 |
| | | | | WO | 2018196683 | A1 | 01 November 2018 |
| | | | | US | 2020059934 | A1 | 20 February 2020 |
| | | | | US | 11071116 | B2 | 20 July 2021 |
| CN | 109150378 | A | 04 January 2019 | WO | 2018228596 | A1 | 20 December 2018 |
| WO | 2018127155 | A1 | 12 July 2018 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 202210693015